# EUROPÄISCHE PATENTANMELDUNG

(11) **EP 3 961 697 A1**
(43) Veröffentlichungstag der Anmeldung: **02.03.2022**
(21) Anmeldenummer: 20192526.0
(22) Anmeldetag: 25.08.2020
(51) Int. Cl.: H01L 23/367, H01L 23/40

(54) **HALBLEITERMODUL MIT EINER VERTIEFUNG**

(71) Anmelder: Siemens Aktiengesellschaft, 80333 München (DE)
(72) Erfinder: Kögler, Roman, 90403 Nürnberg (DE); Luft, Alexander, 90766 Fürth (DE); Roppelt, Bernd, 96191 Viereth-Trunstadt (DE); Schmenger, Jens, 91301 Forchheim (DE); Schwinn, Thomas, 91074 Herzogenaurach (DE)

(57) **Zusammenfassung**

Die Erfindung betrifft eine Halbleiteranordnung (1), umfassend ein Halbleitermodul (2) und eine elektronische Schaltung (4), wobei das Halbleitermodul (2) für die Verbindung mit einem Kühlkörper (3) eingerichtet ist. Zur Verbesserung der Halbleiteranordnung (1) insbesondere im Hinblick auf die Anwendung des Halbleiteranordnung (1) in einem Stromrichter (10) wird vorgeschlagen, dass die elektronische Schaltung (4) auf einer Platine (5) angeordnet ist, wobei die Platine (5) mit der elektronischen Schaltung (4) auf einer vom Kühlkörper (3) abgewandten Fläche (21) des Halbleitermoduls (2) an dem Halbleitermodul (2) befestigt ist, wobei die vom Kühlkörper (3) abgewandten Fläche (21) des Halbleitermoduls (2) eine Vertiefung (6) aufweist, wobei auf der Platine (5) angeordnete elektronische Bauelemente (41) der elektronischen Schaltung (4) in die Vertiefung (6) des Halbleitermoduls (2) hineinragen. Ferner betrifft die Erfindung einen Stromrichter (10) mit mindestens einer derartigen Halbleiteranordnung (1).

## Beschreibung

Die Erfindung betrifft eine Halbleiteranordnung, umfassend ein Halbleitermodul und eine elektronische Schaltung, wobei das Halbleitermodul für die Verbindung mit einem Kühlkörper eingerichtet ist. Ferner betrifft die Erfindung einen Stromrichter mit einer derartigen Halbleiteranordnung.

Der aktuelle Trend der Halbleiterentwicklung geht derzeit hauptsächlich in Richtung Baugrößenreduzierung bestehender Systeme oder/und Leistungserhöhung bei fixer Baugröße. Diese können dann für leistungsfähigere Stromrichter eingesetzt werden. Ein Stromrichter ist ein Beispiel für einen Leistungsmodul, bei dem mit Hilfe von Halbleitern ein Strom und/oder eine Spannung umgewandelt wird.

Bei der Baugrößenreduzierung stand bisher eine verbesserte Entwärmung bzw. Kühlung durch effektivere Kühlkörper oder leistungsfähigere Lüfter im Vordergrund. Hier ist man jedoch an die Grenzen gestoßen, da höhere Preise beispielsweise eines Kupferkühlkörpers oder die Lautstärke eines hochdrehenden Lüfters vom Markt nicht akzeptiert werden. Weiterhin ist bestehendes, nicht benötigtes Gerätevolumen über verschiedene Optimierungsmaßnahmen bereits ausgeschöpft, wodurch eine weitere Reduzierung nicht oder nur mit hohem Aufwand mehr möglich ist.

Dies betrifft insbesondere Halbleiter der Leistungselektronik. Diese sogenannten Leistungshalbleiter weisen eine Stromtragfähigkeit von mehr als 1 Ampere und Spannungen von mehr als 24 Volt auf. Die Obergrenze dieser Größen betragen jeweils mehrere Tausend Ampere oder Volt.

Die Reduzierung der Baugröße von Stromrichtern kann auch durch Einsatz auch SiC-Leistungshalbleiter erreicht werden. Hier können durch höhere Taktfrequenzen der Leistungshalbleiter Teile des Eingangsfilters im Volumen zum Teil deutlich reduziert werden. Eine weitere Option der Baugrößenreduzierung ist, einen Innenraumlüfter im Stromrichter anzuordnen. Dies ist meist aber aus Gründen der Verschmutzung im Inneren der Geräte nicht gewünscht.

Mit dem Begriff Halbleitermodul ist die bauliche Einheit gemeint, der die Funktion eines oder mehrerer Halbleiterschalter umfasst. Diese sind dann beispielsweise in einem Gehäuse untergebracht, um die bauliche Einheit zu bilden.

Der Erfindung liegt die Aufgabe zugrunde, eine Halbleiteranordnung insbesondere im Hinblick auf die Verwendung in einem Stromrichter zu verbessern.

Diese Aufgabe wird durch eine Halbleiteranordnung, umfassend ein Halbleitermodul und eine elektronische Schaltung, gelöst, wobei das Halbleitermodul für die Verbindung mit einem Kühlkörper eingerichtet ist, wobei die elektronische Schaltung auf einer Platine angeordnet ist, wobei die Platine mit der elektronischen Schaltung auf einer vom Kühlkörper abgewandten Fläche des Halbleitermoduls an dem Halbleitermodul befestigt ist, wobei die vom Kühlkörper abgewandten Fläche des Halbleitermoduls eine Vertiefung aufweist, wobei auf der Platine angeordnete elektronische Bauelemente der elektronischen Schaltung in die Vertiefung des Halbleitermoduls hineinragen. Ferner wird diese Aufgabe durch einen Stromrichter mit mindestens einer derartigen Halbleiteranordnung gelöst.

Weitere vorteilhafte Ausgestaltungen der Erfindung sind in den abhängigen Ansprüchen angegeben.

Der Erfindung liegt unter anderem die Erkenntnis zugrunde, dass sich die Halbleiteranordnung dadurch verbessern lässt, dass die elektronische Schaltung zumindest auf der Seite der Platine angeordnet ist, die dem Halbleitermodul zugewandt ist. Dies ist im Allgemeinen aufgrund des geringen Abstandes zwischen Platine und Halbleitermodul nur für besonders kleine Bauteile wie Widerstände, Kondensatoren in kleinen SMD-Bauformen möglich. Die Vertiefung des Halbleitermoduls an der der Platine zugewandten Seite erlaubt darüber hinaus auch die Anordnung größerer Bauteile wie beispielsweise Impulskondensatoren, Keramikkondensatoren oder Folienkondensatoren auf der Seite der Platine, die dem Halbleitermodul zugewandt ist. Diese Bauteile ragen dann in die Vertiefung des Halbleitermoduls. Somit müssen diese nicht auf der dem Halbleitermodul abgewandten Seite der Platine angeordnet werden. Eine solche Bedingung macht ansonsten das Routen der einzelnen Verbindungen auf einer bestückten Platine unmöglich. Bauraum und Leiterplattenfläche lassen sich dann dadurch einsparen, dass man an der Stelle der Vertiefung größere Bauelemente vorsehen kann, die in die Vertiefung hineinragen und an Stelle ohne Vertiefung kleinere Bauteile, insbesondere Bauteile in SMD Technik, anordnet. Durch diesen Freiheitsgrad ist ein Routen der einzelnen Signale möglich. Dabei ist das Routen im Bereich des Halbleitermoduls insbesondere durch frei positioniere Anschlüsse möglich. Somit ist es vorteilhaft, die Anschlüsse in Abhängigkeit von den Bauelementen der elektronischen Schaltung anzuordnen.

Durch die Vertiefung des Halbleitermoduls ergibt sich die Möglichkeit, die Platine beidseitig zu bestücken. Mit anderen Worten ist es vorteilhaft, wenn die Platine beidseitig bestückt ist. Damit stehen zwei Flächen auf den beiden Seiten der Platine für die Aufnahme von elektronischen Bauelementen zur Verfügung. Durch den Freiheitsgrad der Anordnung von großen Bauelementen auf beiden Seiten der Platine in unmittelbarer Nähe des Halbleitermoduls ist die Realisierung einer elektronischen Schaltung auf einer beidseitig bestückten Platine mit geringen Abmessungen möglich. Dadurch kann die Leiterplattenfläche, auf der die elektronische Schaltung angeordnet ist, zum Teil doppelt genutzt und damit gut ausgenutzt werden.

Durch den aufgrund der Vertiefung am Halbleitermodul neu hinzugewonnen Freiheitsgrad der Platzierung der Bauelemente auf der dem Halbleitermodul zugewandten Seite der Platine ist es nun möglich, schaltungstechnisch nahe am Halbleitermodul anzuordnende Bauelement auch mit kurzen Verbindungswegen zur Halbleiteranordnung anzuordnen. Dies betrifft beispielsweise unter anderem die Ansteuerschaltung eines IGBTs oder die niederinduktive Anbindung von Kondensatoren an den Zwischenkreis über kurze Leitungs- bzw. Verbindungswege.

Bei dem Halbleitermodul handelt es sich um eine bauliche Einheit. Dieses Halbleitermodul kann dabei einen einzelnen Schalter oder auch ein Phasenmodul mit zwei Schaltern umfassen. Ebenso können weitere Schalter in dem Halbleitermodul angeordnet sein, so dass das Halbleitermodul eine Brückenschaltung mit vier, sechs oder noch mehr Schaltern bildet.

Darüber hinaus lassen sich mit heute etablierten Standardhöhen von Gehäusen bei Halbleitermodulen eine Vielzahl der Marktanforderungen erfüllen. Somit hat es sich als vorteilhaft erwiesen, auch für das Halbleitermodul der vorgeschlagenen Halbleiteranordnung eine derartige Standardhöhe als Höhe vorzusehen.

Des Weiteren hat es sich als vorteilhaft erwiesen, die Anschlüsse über die der Platine zugewandten Fläche des Halbleitermoduls zu verteilen. Dadurch ist es einfacher möglich, im Layout der elektronischen Schaltung, beispielsweise aufgrund von Luft-/Kriechstrecken und großen Leiterbahnbreiten für Lastanschlüsse, auch Bauteile auf der dem Halbleitermodul zugewandten Seite der Platine anzuordnen und die zugehörigen Signale dorthin zu routen.

Somit lassen sich durch die Vertiefung im Halbleitermodul und der Platine deren elektronische Bauelemente zum Teil in die Vertiefung ragen eine geschickte Verschachtelung der Halbleiteranordnung erreichen und insbesondere bei einer beidseitigen Bestückung Leiterplattenfläche auf der Platine einsparen. Die Fläche des Gehäuses des Halbleitermoduls, auch als Halbleiterdeckel bezeichnet, erhält vorteilhafterweise an den Stellen, an denen im Innern des Halbleitermoduls ungenutztes Volumen vorhanden ist und in dem Bereich, in dem auf der Platine größere Bauteile platziert werden müssen, eine oder mehrere Vertiefungen, auch als Einbuchtungen oder Taschen bezeichnet, um den Raum für Komponenten auf der Platine nutzbar zu machen. Dadurch kann nicht genutztes Volumen im Halbleitermodul für die Komponenten der elektronischen Schaltung genutzt werden. In einigen Fällen kann darüber hinaus auch die Höhe des Halbleitermoduls verringert werden.

Auch das Design des Halbleitermoduls kann dazu genutzt werden, eine oder mehrere Vertiefungen an bestimmten Stellen des Deckels vorzusehen. Dieser Vorteil lässt sich insbesondere dann besonders gut nutzen, wenn die Anschlüsse des Halbleitermoduls sich über die dem Kühlkörper abgewandten Fläche des Halbleitermoduls verteilen. Dieser Freiheitsgrad kann dazu genutzt werden, die Anschlüsse direkt oberhalb des darunterliegenden Chips anzuordnen und auch die dazugehörigen Schaltungsteile der elektronischen Schaltung in unmittelbarer Nähe zu den Anschlüssen anzuordnen. Dadurch kann die elektromagnetische Verträglichkeit (EMV) der Halbleiteranordnung oder eines Stromrichters mit einer derartigen Halbleiteranordnung zum Teil deutlich verbessert werden. Weiterhin reduzieren sich Kommutierungskreise, so dass sich das Schaltverhalten des Halbleitermoduls, insbesondere bei Einsatz von Leistungselektronik, verbessert und Verluste reduziert werden.

Besonders vorteilhaft ist es, bei einer zweiteiligen Ausführung des Gehäuses des Halbleitermoduls die Anschlüsse im Deckel anzuordnen. Dies vereinfacht die Fertigung des entsprechenden Halbleitermoduls sowie der Halbleiteranordnung.

Durch die vorgeschlagene Halbleiteranordnung ergibt sich ein kompakterer Aufbau, auch bei Geräten wie Stromrichtern, die aus derartigen Halbleiteranordnungen aufgebaut sind und anderen Leistungsmodulen. Alternativ ist es möglich, bei gegebener Bauform und -größe, eine höhere Leistung zu schalten. Beides ergibt eine Vergrößerung der Leistungsdichte der Halbleiteranordnung bzw. eines Stromrichters mit derartigen Halbleiteranordnungen. Gleichzeitig ist die Halbleiteranordnung kostengünstig herstellbar. Durch die Reduktion an Leiterplattenfläche wird die Herstellung sogar noch kostengünstiger als bei bisher bekannten Lösungen. Darüber hinaus verbessert sich auch das Betriebsverhalten und/oder die Einsatzmöglichkeiten der Halbleiteranordnungen bzw. der Stromrichter, da Schaltungsteile der elektronischen Schaltung räumlich näher an dem Halbleitermodul und damit an den Leistungs-Chips des Halbleitermoduls angeordnet werden können.

Bei einer vorteilhaften Ausgestaltung der Erfindung ist die Platine zur Befestigung über elektrische Verbindungen mit elektrischen Anschlüssen des Halbleitermoduls, insbesondere ausschließlich über elektrische Verbindungen, verbunden. Aufgrund der geringen Abmessungen und der damit geringen Kräfte, die auf die Halterung wirken, ist es möglich, die Platine der elektronischen Schaltung allein über die elektrischen Anschlüsse am Halbleitermodul zu befestigen. Der Abstand zwischen der Platine und dem Halbleitermodul ist durch die Vertiefung auch bei beidseitiger Bestückung der Platine derart gering, dass die Kräfte auf die Anschlüsse so gering sind, dass die Anschlüsse neben der Aufgabe der elektrischen Verbindung auch die Aufgabe der mechanischen Verbindung übernehmen können. Dimensioniert man die elektrische Verbindung im Hinblick auf die elektrischen Anforderungen, insbesondere den Querschnitt der Verbindung, so ergibt sich gleichzeitig aufgrund der kurzen Länge der Verbindung auch eine hinreichende mechanische Festigkeit der Verbindung. Darüber hinaus eignet sich die Ausgestaltung der Pins im Bereich außerhalb der Vertiefung, die Montage zu vereinfachen, da die Pins aufgrund ihrer Länge die Löcher der Platine leichter und zielsicher finden können. Somit brauchen zur mechanischen Verbindung keine weiteren Vorrichtungen vorgesehen zu werden.

Bei einer weiteren vorteilhaften Ausgestaltung der Erfindung ist die Platine schraubverbindungsfrei mit dem Halbleitermodul verbunden. Wie zuvor beschrieben wird keine mechanisch belastbare Verbindung zwischen Halbleitermodul und Platine mehr benötigt, da die auftretenden Kräfte aufgrund der geringen Abmessung der Platine und des geringen Abstandes zwischen Platine und Halbleitermodul auch über einfache Verbindungen, wie beispielsweise Steckverbindungen oder über die elektrischen Anschlüsse hinreichend mechanisch belastbar sind. Diese sind darüber hinaus einfach und kostengünstig herstellbar.

Bei einer weiteren vorteilhaften Ausgestaltung der Erfindung sind die Anschlüsse des Halbleitermoduls auf der vom Kühlkörper abgewandten Fläche des Halbleitermoduls außerhalb der Vertiefung angeordnet. Der hohe Aufbau im Bereich der Anschlüsse gibt den Anschlüssen eine besondere Festigkeit. Darüber hinaus eignet sich die Ausgestaltung der Pins im Bereich außerhalb der Vertiefung, die Montage zu vereinfachen, da die Pins aufgrund ihrer Länge die Löcher der Platine leichter und zielsicher finden können. Diese ermöglicht es unter anderem, die Platine mittels der Verbindungen an den Anschlüssen zu befestigen. Die benötigte Verbindung an den Anschlüssen ist besonders kurz, da sich die Anschlüsse außerhalb des Bereichs der Vertiefung befinden. Teilweise ist es sogar möglich, die Platine direkt an dem Anschluss des Halbleitermoduls zu befestigen. Die entsprechende Verbindung ist entsprechend kurz, so dass nur geringe Kräfte bei der Befestigung aufgenommen werden müssen. Darüber hinaus ist es auch möglich, das Gehäuse des Halbleitermoduls in einer Standardhöhe auszuführen. Die Höhe ist der Abstand zwischen der Fläche, an dem sich der Kühlkörper befindet zu der der Platine zugewandten Fläche des Halbleitermoduls. Da sich die Anschlüsse in dem Bereich außerhalb der Vertiefung befinden, können die Halbleitermodule mit Vertiefung universell auch in bestehende Anwendungen eingesetzt werden. Durch den Stückzahleffekt ist die Halbleiteranordnung dann kostengünstig herstellbar.

Bei einer weiteren vorteilhaften Ausgestaltung der Erfindung weist das Halbleitermodul das Material Siliziumcarbid und/ oder Galliumnitrit auf. Dieses Halbleitermaterial erlaubt den Aufbau von Halbleitermodulen mit einer besonders hohen Schaltfrequenz. Diese liegt im zwei- bzw. dreistelligen kHz-Bereich. Durch das schnelle Schalten wird auch eine besonders niederinduktive Ansteuerung und Verbindung zum Zwischenkreis benötigt. Dies kann mit der vorgeschlagenen Anordnung der Halbleiteranordnung besonders einfach und kostengünstig realisiert werden. Zum einen können die Zwischenkreiskondensatoren mit geringem Abstand zum Halbleitermodul und den dazugehörigen Halbleiterchips angeordnet werden. Darüber hinaus können auch die für die Ansteuerung erforderlichen Baugruppen der elektronischen Schaltung in der Nähe der Ansteueranschlüsse des Halbleitermoduls angeordnet werden. Beides ermöglicht den sicheren und zuverlässigen Betrieb des Halbleitermoduls mit einer besonders hohen Schaltfrequenz.

Bei einer weiteren vorteilhaften Ausgestaltung der Erfindung umfasst die Halbleiteranordnung mindestens zwei Halbleitermodule. Mit dieser Anordnung lässt sich auf einfache Weise ein Brückenzweig oder auch eine gesamte Halbbrücke realisieren. Da es zwischen den Elementen eines Brückenzweigs bzw. einer Halbbrücke Abhängigkeiten wie beispielsweise Verriegelungen und Verriegelungszeiten gibt, hat es sich als vorteilhaft erwiesen, diese Halbleitermodule so anzuordnen, dass sie mit genau einer Platine der elektronischen Schaltung verbunden sind. Ganz besonders bei einer Parallelschaltung mehrerer Halbleitermodule ist es aufgrund gleicher Ansteuersignale im Besonderen vorteilhaft, diese Halbleitermodule mit nur einer elektronischen Schaltung zu verbinden, da diese Schaltung aufgrund gleicher Ansteuersignale für die Halbleitermodule besonders einfach aufgebaut ist. Somit kann zur Ansteuerung oder Versorgung eine Platine für mehrere Halbleitermodule zum Einsatz kommen. Dadurch ist ein besonders kompakter Aufbau eines Stromrichters möglich.

Bei einer weiteren vorteilhaften Ausgestaltung der Erfindung weist die Halbleiteranordnung den Kühlkörper auf und ist ein Substrat des Halbleitermoduls direkt mit dem Kühlkörper nichtlösbar verbunden. Durch das Aufbringen des Substrates, beispielsweise durch Löten, Sintern, Kleben und/oder Drucken, sowie einer Kombination aus diesen Fertigungsmöglichkeiten, und damit des Halbleitermaterials auf den Kühlkörper kann ein besonders guter Wärmeübergang erzeugt werden. Darüber hinaus sind Kühlkörper und Halbleitermodul kraftschlüssig miteinander verbunden. Unabhängig davon, wie die Halbleiteranordnung in einem Stromrichter befestigt ist, kann dann auch die elektronische Schaltung mittels der Verbindung zu den elektrischen Anschlüssen des Halbleitermoduls mechanisch mit dem Halbleitermodul verbunden werden. Dies ist insbesondere dann der Fall, wenn mehrere Halbleitermodule mit einer Platine der elektronischen Schaltung verbunden sind. Somit ist es besonders vorteilhaft, wenn mindestens zwei Halbleitermodule auf einem Kühlkörper angeordnet sind. Damit übernimmt dann der Kühlkörper auch die Funktionalität, die mindestens zwei Halbleitermodule zueinander auszurichten und zu positionieren, so dass dann eine Platine mit der elektronischen Schaltung mit mehreren Halbleitermodulen verbunden werden kann, ohne unzulässig hohe Kräfte aufnehmen zu müssen.

Im Folgenden wird die Erfindung anhand der in den Figuren dargestellten Ausführungsbeispiele näher beschrieben und erläutert. Es zeigen:
- FIG 1: ein Teil einer Halbleiteranordnung,
- FIG 2: ein Schnitt durch eine Halbleiteranordnung und
- FIG 3: einen Stromrichter.

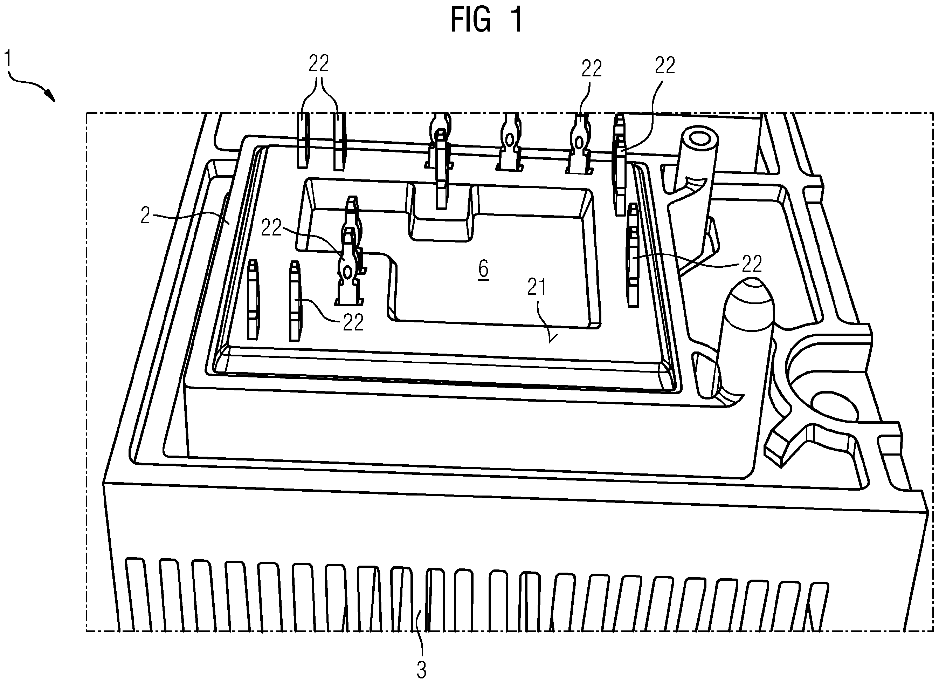

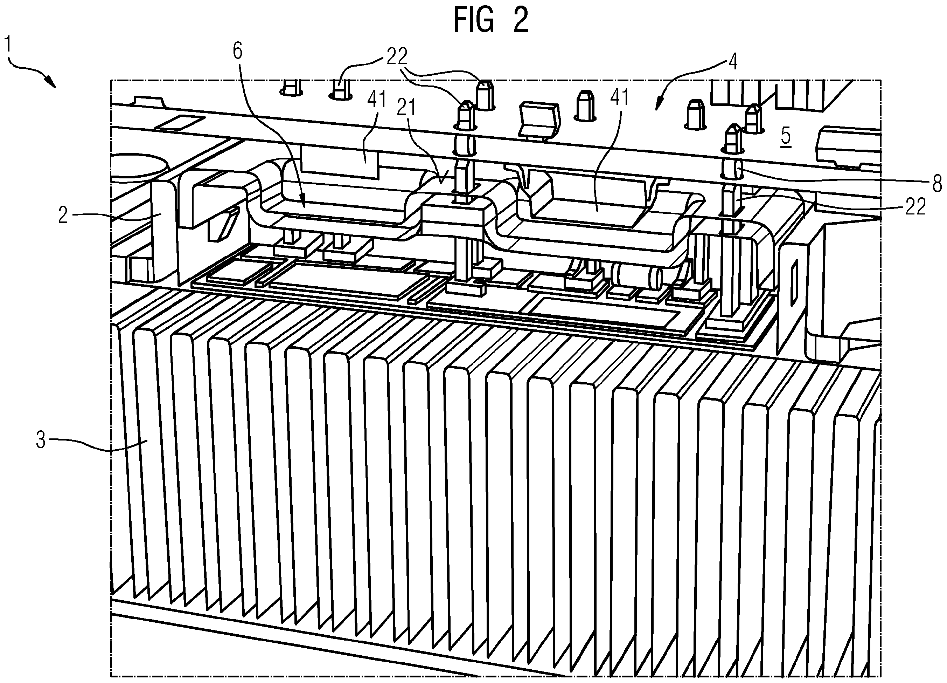

Die FIG 1 zeigt einen Teil einer Halbleiteranordnung 1. In diesem Ausführungsbeispiel ist ein Halbleitermodul 2 mit einem Kühlkörper 3 verbunden. Die Verbindung kann beispielsweise nichtlösbar ausgeführt sein. Diese kann dadurch realisiert werden, dass das Substrat des Halbleitermoduls 2 direkt auf den Kühlkörper 3 aufgetragen wurde und somit das Substrat des Halbleitermoduls 2 direkt mit dem Kühlkörper 3 verbunden ist. In dieser Darstellung ist das Halbleitermodul 2 zweiteilig ausgeführt. Das Gehäuse weist dabei einen Grundkörper und einen Deckel auf, wobei der Deckel durch die vom Kühlkörper abgewandten Fläche 21 des Halbleitermoduls 2 gebildet wird. An dieser Fläche 21 sind auch die Anschlüsse 22 des Halbleitermoduls 2 angeordnet, an denen eine hier nicht dargestellte Platine 5 mit einer elektronischen Schaltung 4 befestigt werden kann. Damit zum einen die Anschlüsse 22 zur Befestigung der Platine 5 kurz, also mit geringer Länge, ausgeführt werden können und trotzdem die Platine 5 beidseitig bestückt werden kann, ist an der vom Kühlkörper abgewandten Fläche 21 des Halbleitermoduls 2 eine Vertiefung 6 vorhanden. Die FIG 2 zeigt in einer Schnittdarstellung, dass elektronische Bauelemente 41 der elektrischen Schaltung 4 auf der Platine 5 in die Vertiefung 6 des Halbleitermoduls 2 hineinragen können. Damit kann sichergestellt werden, dass der Abstand zwischen Halbleitermodul 2 und Platine 5 auch bei der Anordnung größerer Komponenten wie beispielsweise Impulskondensatoren, Keramikkondensatoren oder Elektrolytkondensatoren derart gering gewählt werden kann, dass die Platine 5 an den Anschlüssen 22 des Halbleitermoduls 2, die eine elektrische Verbindung 8 zwischen der Platine 5 und dem Halbleitermodul 2 bilden, befestigt werden kann. Zur Vermeidung von Wiederholungen wird auf die Beschreibung zur FIG 1 sowie auf die dort eingeführten Bezugszeichen verwiesen.

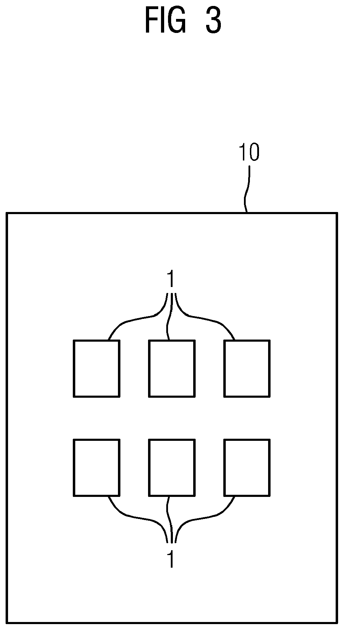

Die FIG 3 zeigt einen Stromrichter 10, der eine Vielzahl von Halbleiteranordnungen 1 aufweist.

Zusammenfassend betrifft die Erfindung eine Halbleiteranordnung, umfassend ein Halbleitermodul und eine elektronische Schaltung, wobei das Halbleitermodul für die Verbindung mit einem Kühlkörper eingerichtet ist. Zur Verbesserung der Halbleiteranordnung insbesondere im Hinblick auf die Anwendung der Halbleiteranordnung in einem Stromrichter wird vorgeschlagen, dass die elektronische Schaltung auf einer Platine angeordnet ist, wobei die Platine mit der elektronischen Schaltung auf einer vom Kühlkörper abgewandten Fläche des Halbleitermoduls an dem Halbleitermodul befestigt ist, wobei die vom Kühlkörper abgewandten Fläche des Halbleitermoduls eine Vertiefung aufweist, wobei auf der Platine angeordnete elektronische Bauelemente der elektronischen Schaltung in die Vertiefung des Halbleitermoduls hineinragen. Ferner betrifft die Erfindung einen Stromrichter mit mindestens einer derartigen Halbleiteranordnung.

## Patentansprüche

1. Halbleiteranordnung (1), umfassend ein Halbleitermodul (2) und eine elektronische Schaltung (4), wobei das Halbleitermodul (2) für die Verbindung mit einem Kühlkörper (3) eingerichtet ist, wobei die elektronische Schaltung (4) auf einer Platine (5) angeordnet ist, wobei die Platine (5) mit der elektronischen Schaltung (4) auf einer vom Kühlkörper (3) abgewandten Fläche (21) des Halbleitermoduls (2) an dem Halbleitermodul (2) befestigt ist, wobei die vom Kühlkörper (3) abgewandten Fläche (21) des Halbleitermoduls (2) eine Vertiefung (6) aufweist, wobei auf der Platine (5) angeordnete elektronische Bauelemente (41) der elektronischen Schaltung (4) in die Vertiefung (6) des Halbleitermoduls (2) hineinragen.

2. Halbleiteranordnung (1) nach Anspruch 1, wobei die Platine (5) zur Befestigung über elektrische Verbindungen (8) mit elektrischen Anschlüssen (22) des Halbleitermoduls (2), insbesondere ausschließlich über elektrische Verbindungen (8), verbunden ist.

3. Halbleiteranordnung (1) nach einem der Ansprüche 1 oder 2, die Platine (5) schraubverbindungsfrei mit dem Halbleitermodul (2) verbunden ist.

4. Halbleiteranordnung (1) nach einem der Ansprüche 1 bis 3, wobei die Anschlüsse (22) des Halbleitermoduls (2) auf der vom Kühlkörper (3) abgewandten Fläche (21) des Halbleitermoduls (2) außerhalb der Vertiefung (6) angeordnet sind.

5. Halbleiteranordnung (1) nach einem der Ansprüche 1 bis 4, wobei das Halbleitermodul (2) das Material Siliziumcarbid und/oder Galliumnitrit aufweist.

6. Halbleiteranordnung (1) nach einem der Ansprüche 1 bis 5, wobei die Halbleiteranordnung (1) mindestens zwei Halbleitermodule (2) auf genau einem Kühlkörper (3) umfasst.

7. Halbleiteranordnung (1) nach einem der Ansprüche 1 bis 6, wobei die Halbleiteranordnung (1) den Kühlkörper (3) umfasst und ein Substrat des Halbleitermoduls (2) direkt mit dem Kühlkörper (3) nichtlösbar verbunden ist.

8. Stromrichter (10) mit mindestens einer Halbleiteranordnung (1) nach einem der Ansprüche 1 bis 7.
